# EUROPEAN PATENT APPLICATION

(11) **EP 1 833 083 A1**
(43) Date of publication of application: **12.09.2007**
(21) Application number: 05816858.4
(22) Date of filing: 15.12.2005
(51) Int. Cl.: H01L 21/304

(54) **SILICON WAFER POLISHING METHOD AND SILICON WAFER PRODUCING METHOD, APPARATUS FOR POLISHING DISC-LIKE WORK AND SILICON WAFER**

(30) Priority: 28.12.2004 JP 2004379526
(71) Applicant: SHIN-ETSU HANDOTAI COMPANY LIMITED, Chiyoda-ku Tokyo 100-0005 (JP)
(72) Inventor: MIZUSHIMA, Kazutoshi, Shirakawa Plant, Nishishira-gun, Fukushima 961-8061 (JP)
(74) Representative: Wibbelmann, Jobst
(86) International application number: PCT/JP2005/023024
(87) International publication number: WO 2006/070607

(57) **Abstract**

The present invention is a method for polishing a silicon wafer, in which an oxide film is formed on a back surface side of the wafer, wherein the oxide film on a chamfered portion of the silicon wafer is removed, and the oxide film on a peripheral portion of the back surface of the wafer is polished over at least 2 mm from the outermost peripheral portion of the back surface of the wafer so that a thickness of the polished oxide film decreases from inside to outside of the wafer, a method for producing such a silicon wafer, and a silicon wafer. Thereby, there are provided a method for polishing a silicon wafer in which particles' attaching to a wafer surface after handling can be prevented, decrease of resistivity due to autodoping is not brought about, and moreover, productivity does not decrease; a method for producing such a silicon wafer; an apparatus for polishing a disk-shaped workpiece suitable for performing the methods; and a silicon wafer in which particles do not attach to a surface after handling even if an oxide film is formed on a back surface of the wafer and decrease of resistivity due to autodoping is not brought about.

## Description

### Technical Field

The present invention relates to a method for polishing a silicon wafer, a method for producing a silicon wafer, an apparatus for polishing a disk-shaped workpiece, and a silicon wafer. To be more specific, the present invention relates to a method for polishing a silicon wafer in which an oxide film is formed on a back surface and a chamfered portion of the wafer, a method for producing such a silicon wafer, an apparatus for polishing a disk-shaped workpiece suitable for the polishing method, and a silicon wafer in which an oxide film is formed on a back surface of the wafer.

### Background Art

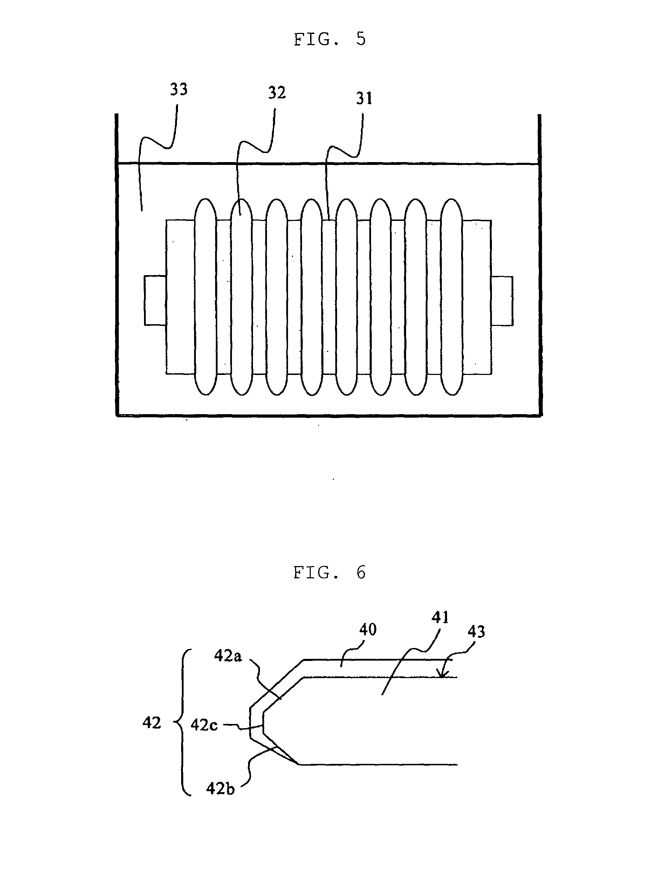

When a thin film is formed on a front surface of a semiconductor silicon wafer by epitaxial growth, in order to prevent so-called autodoping
in which impurities in the silicon wafer are introduced into an epitaxial layer, an oxide film having thickness of, for example, approximately several hundred nm is formed on a back surface of the silicon wafer, that is, a surface opposite to the front surface on which the epitaxial layer is formed, through CVD (Chemical Vapor Deposition) and the like. Fig. 6 is a partial cross-sectional schematic view showing a peripheral portion of a silicon wafer in which an oxide film is formed on a back surface of the wafer. As for this silicon wafer 41, a chamfered portion 42 comprising a chamfered surface 42a of a back surface side, a chamfered surface 42b of a front surface side and a peripheral surface 42c is formed with a chamfering processing machine with the view of preventing cracking in the peripheral portion, and an oxide film 40 is formed on the back surface 43 of the wafer and the chamfered portion 42.

As described above, an oxide film is formed not only on a back surface of a silicon wafer but also on a chamfered portion, the periphery of the wafer. However, when an epitaxial layer is grown on such a wafer, there are some cases where polycrystals extraordinarily grow to form projections called nodules on the oxide film on the chamfered portion, and breakage and separation of the nodules cause damages to the epitaxial growth layer. Therefore, as for such a silicon wafer, usually, the oxide film on the chamfered portion of the wafer is removed, then epitaxial growth is performed.

For a method for removing an oxide film on a chamfered portion of a wafer, there can be mentioned a method (conventional art 1), wherein the oxide film is removed by polishing the chamfered portion on which the oxide film is formed with pressing the chamfered portion against a rotating roll buff, as described in, for example, Japanese Patent Laid-Open (kokai) No.8-85051. Moreover, there can be mentioned a method (conventional art 2), wherein a wafer is polished with being pressed against a polishing jig having a concave polishing surface, as described in Japanese Patent Laid-Open (kokai) No.2000-317788. Hereinafter, each conventional art is explained using Figures.

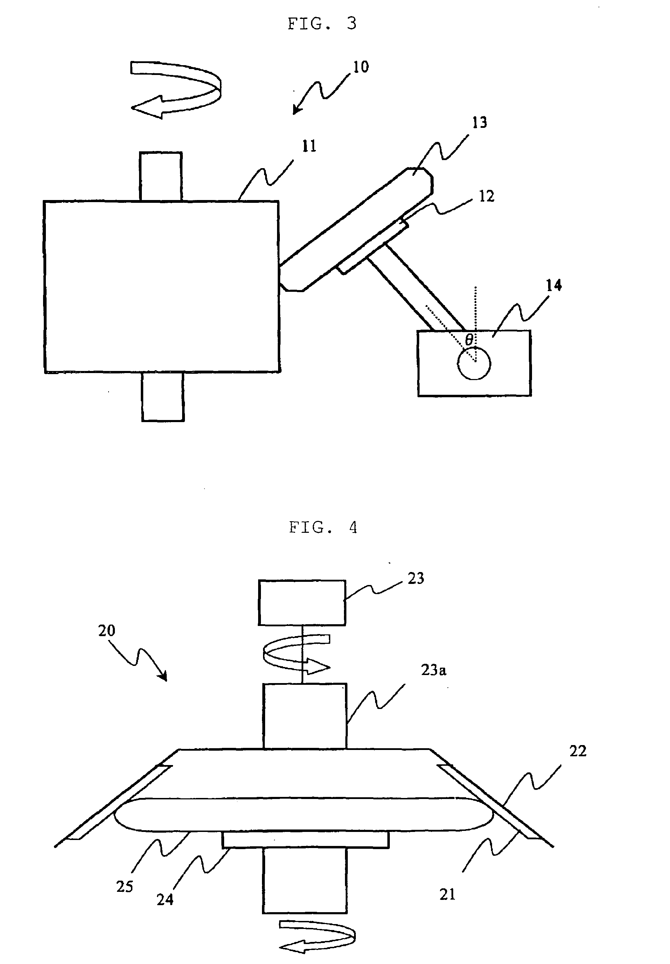

Fig. 3 is a schematic view showing a polishing apparatus according to conventional art
1. In this polishing apparatus 10, a chamfered portion of a wafer 13 is contacted with a rotating roll buff 11, then polishing is performed with a polishing agent provided. In this case, the wafer 13 is held with a wafer holder 12, and the wafer 13 is inclined by a stage 14 in which the wafer holder 12 is set so that an inclined surface of the chamfered portion of the wafer (a chamfered surface) and a surface of the roll buff 11 become parallel, then polishing is performed.

Furthermore, Fig. 4 is a schematic view showing a polishing apparatus according to conventional art 2. This polishing apparatus 20 comprises a rotating body 22 having a surface inclined concentrically from outside to inside in a curved line or a straight line in which a polishing pad 21 is attached to the surface, and the rotating body 22 is rotated and driven by a motor 23 through a drive shaft 23a. Then, a wafer 25 is held with a wafer holder 24, a chamfered portion of the wafer is pressed against the polishing pad 21, and the chamfered portion is polished.

In the case of conventional art 2, as a polishing surface of the polishing pad is in contact with the whole polished surface of a peripheral portion of the wafer at the same time, there is provided an effect that a polishing rate remarkably increases as compared with polishing using such a roll buff as in conventional art 1. Moreover, Japanese Patent Laid-Open (kokai) No.2000-317788 discloses a mirror polishing method, by which an oxide film can be removed when a polishing agent is changed.

Moreover, for a conventional method for removing an oxide film on a chamfered portion of a wafer, there can be also mentioned a method wherein stacked plural wafers 32 with spacers 31 put between the wafers are immersed into a hydrofluoric acid solution 33 for a given time to dissolve and remove oxide films on chamfered portions (conventional art 3). In this case, because parts sandwiched by the spacers 31 are not in contact with the hydrofluoric acid, when the wafers 32 are sandwiched with spacers having a given diameter, the oxide films on back surfaces of the wafers 32 are protected and only the oxide films on the chamfered portions can be removed.

However, there have been some cases where each wafer in which a chamfered portion is polished to remove an oxide film in the above-mentioned conventional arts causes the problem that particles attach to a wafer surface when subjected to handling such as transfer with a wafer shipping box or an edge handling transfer robot. Furthermore, this problem has occurred also in a wafer in which an oxide film on a chamfered portion is removed by the above-described method wherein a wafer is immersed in hydrofluoric acid.

### Disclosure of the Invention

The present invention was conceived in view of the above problem. The object of the present invention is to provide a method for polishing a silicon wafer in which particles' attaching to a wafer surface after handling can be prevented, decrease of resistivity due to autodoping is not brought about, and moreover, productivity does not decrease; a method for producing such a silicon wafer; an apparatus for polishing a disk-shaped workpiece suitable for perform the methods; and a silicon wafer in which particles do not attach to a surface after handling even if an oxide film is formed on a back surface of the wafer and decrease of resistivity due to autodoping is not brought about.

To achieve the above-mentioned object, according to the present invention, there is provided a method for polishing a silicon wafer, in which an oxide film is formed on a back surface side of the wafer, wherein at least, the oxide film on a chamfered portion of the silicon wafer is removed, and the oxide film on a peripheral portion of the back surface of the wafer is polished over at least 2 mm from the outermost peripheral portion of the back surface of the wafer so that a thickness of the polished oxide film decreases from inside to outside of the wafer.

As described above, the oxide film on a chamfered portion of the silicon wafer is removed, and the oxide film on a peripheral portion of the back surface of the wafer is polished over at least 2 mm from the outermost peripheral portion of the back surface of the wafer so that a thickness of the polished oxide film decreases from inside to outside of the wafer. When the oxide film is polished over at least 2 mm from the outermost peripheral portion as described above, particle generation due to breakage of the oxide film caused in wafer handling can be remarkably reduced without the flatness of the peripheral portion of the wafer lowered. Therefore, it becomes possible to prevent particles caused due to the particle generation from attaching to the wafer surface. Furthermore, because the oxide film is not completely removed through polishing, it becomes possible that the back surface of the wafer is not exposed, and autodoping during epitaxial growth is not brought about. The outermost peripheral portion of the back surface mentioned here means a boundary between an inclined surface of the chamfered portion of the wafer (a chamfered surface) and a flat portion of the back surface.

In this case, it is preferable that the oxide film on the outermost peripheral portion of the back surface of the wafer is polished by 50 nm or more.

When the oxide film on the outermost peripheral portion of the back surface of the wafer is polished by 50 nm or more as described above, there can be obtained higher effect of reducing the particle generation due to breakage of the oxide film, so that it becomes possible to surely prevent particles' attaching to the wafer surface.

Moreover, it is preferable that the oxide film on the chamfered portion of the wafer is removed, and at the same time, the oxide film on the peripheral portion of the back surface of the wafer is polished.

When the oxide film on the chamfered portion of the wafer is removed, and at the same time, the oxide film on the peripheral portion of the back surface of the wafer is polished as described above, it becomes possible that the wafer is polished with high productivity as compared with the case where the two steps are performed separately.

Further, it is preferable that any one of the above-described polishing methods comprises further a step of removing the oxide film on a chamfered surface of a front surface side and a peripheral surface in the chamfered portion of the wafer.

When the above-described polishing methods comprise further a step of removing the oxide film on a chamfered surface of a front surface side and a peripheral surface in the chamfered portion of the wafer as described above, it becomes possible that the oxide film on the whole chamfered portion is surely removed and nodules are prevented from generating on the oxide film on the chamfered portion during epitaxial growth.

Furthermore, according to the present invention, there is provided a method for producing a silicon wafer wherein after the oxide film on the chamfered portion is removed and the oxide film on the peripheral portion of the back surface of the wafer is polished by any one of the above-described polishing methods, epitaxial growth is performed on a front surface of the wafer.

When after the oxide film on the chamfered portion is removed and the oxide film on the peripheral portion of the back surface of the wafer is polished by any of the above-described polishing methods, epitaxial growth is performed on a front surface of the wafer as described above, it becomes possible that a silicon wafer in which particles' attaching to a surface of an epitaxial layer due to a subsequent handling is prevented, and resistivity of the epitaxial layer does not decrease as autodoping is not brought about during epitaxial growth is produced.

Moreover, the present invention provides an apparatus for polishing a disk-shaped workpiece, comprising, at least, a rotating body having a surface inclined concentrically from outside to inside in a curved line or a straight line in which a polishing pad is attached to the surface; a driving means rotating and driving the rotating body; a workpiece holder holding the disk-shaped workpiece and pressing a peripheral portion of the workpiece against the polishing pad, wherein the polishing pad comprises a chamfered-portion polishing part in which a chamfered portion of the workpiece is polished and a back-surface polishing part in which a back surface of the workpiece is polished, and the polishing pad is attached to the rotating body so that an angle (α) which a tangent plane on a point of contact between the chamfered-portion polishing part and the chamfered portion of the workpiece forms with a rotation axis is in the range of 40° to 70°, and an angle (β) which a contact surface between the back-surface polishing part and the back surface of the workpiece forms with the rotation axis is in the range of 90° to 110°.

As shown in Fig. 4, a conventional polishing apparatus does not have such a structure that a polishing pad is in contact with a back surface of a wafer. However, with the polishing apparatus according to the present invention, the back-surface polishing part and the chamfered-portion polishing part of the polishing pad are respectively in contact with the peripheral portion of the back surface and the chamfered surface of the disk-shaped workpiece at proper angles, so that sufficient polishing can be achieved. Particularly, because the peripheral portion of the back surface and the chamfered surface of the back surface side can be polished at the same time, polishing with high productivity can be achieved as compared with the case where they are polished separately.

Here, when the angle (α) is less than 40°, the point of contact will be positioned in the peripheral side of the chamfered surface, so that a portion in the inner side of the chamfered surface cannot be polished. Moreover, when the angle (α) is more than 70°, the point of contact will be positioned in the inner side of the chamfered surface, so that the peripheral side of the chamfered surface cannot be polished. Further, when the angle (β) is more than 110°, the contact surface will be in contact with the peripheral portion of the back surface at the peripheral side, so that the inner region of the peripheral portion of the back surface cannot be polished, particularly, as for the region over at least 2 mm from the outermost peripheral portion of the back surface of the workpiece, not all of the region can be polished. Moreover, when the angle (β) is less than 90°, the contact surface will be in contact with the peripheral portion of the back surface at the inner side, so that the outermost peripheral portion cannot be polished.

However, when the angles α and β are in the ranges defined in the present invention, it becomes possible that sufficient polishing is achieved as to the whole region of the chamfered surface, and that as to the whole of the region in the peripheral portion of the back surface over at least 2 mm from the outermost peripheral portion, sufficient polishing is achieved, and also the oxide film is polished so that a thickness of the polished oxide film decreases from inside to outside.

In this case, it is preferable that the disk-shaped workpiece is a silicon wafer.

When the disk-shaped workpiece is a silicon wafer as described above, it becomes possible that the oxide film on the peripheral portion of the back surface is polished and at the same time, the oxide film on a chamfered surface of a back surface side is polished to be removed, so that the polishing apparatus with high productivity can be achieved. Furthermore, it becomes possible that the peripheral portion of the back surface over at least 2 mm from the outermost peripheral portion of the back surface of the silicon wafer is sufficiently polished, so that the polishing apparatus which can polish the silicon wafer to provide a silicon wafer in which particles do not attach to the wafer surface and autodoping during epitaxial growth is not brought about can be achieved.

Moreover, according to the present invention, there is provided a silicon wafer in which an oxide film is formed on a back surface of the wafer, wherein, at least, on a peripheral portion of the back surface over at least 2 mm from the outermost peripheral portion of the back surface of the wafer, a thickness of the oxide film decreases from inside to outside of the wafer.

In a silicon wafer in which an oxide film is formed on a back surface of the wafer, wherein on a peripheral portion of the back surface over at least 2 mm from the outermost peripheral portion of the back surface of the wafer, a thickness of the oxide film decreases from inside to outside of the wafer as described above, particle generation caused in wafer handling can be remarkably reduced without the flatness of the peripheral portion of the wafer lowered. Therefore, a silicon wafer in which particles do not attach to the wafer surface, and decrease of resistivity due to autodoping during epitaxial growth is not brought about can be achieved.

In this case, it is preferable that the thickness of the oxide film on the outermost peripheral portion of the back surface of the wafer is 50 nm or more thinner than the thickness of the oxide film on a central portion of the back surface of the wafer.

When the thickness of the oxide film on the outermost peripheral portion of the back surface of the wafer is 50 nm or more thinner than the thickness of the oxide film on a central portion as described above, the effect that particles' attaching to the wafer surface is prevented owing to the reduction of particle generation can be achieved with more certainty.

Moreover, it is preferable that an epitaxial layer is formed on a front surface of the wafer.

When an epitaxial layer is formed on a front surface of the wafer as described above, a silicon wafer in which particles do not attach to a surface of the epitaxial layer, and decrease of resistivity of the epitaxial layer due to autodoping is not brought about can be achieved.

By the method for polishing a silicon wafer according to the present invention, particle generation caused in wafer handling can be remarkably reduced, so that particles due to particle generation can be prevented from attaching to the wafer surface, and autodoping during epitaxial growth can also be prevented.

Furthermore, by the method for producing a silicon wafer according to the present invention, a silicon wafer in which particles' attaching to the surface of the epitaxial layer due to handling is prevented, and resistivity of the epitaxial layer does not decrease as autodoping is not brought about during epitaxial growth can be produced.

Moreover, with the apparatus for polishing a disk-shaped workpiece according to the present invention, the peripheral portion of the back surface and the chamfered surface of the back surface side of the workpiece can be sufficiently polished at the same time, so that polishing with high productivity can be achieved. Particularly, the whole of the region over at least 2 mm from the outermost peripheral portion of the back surface of the workpiece can be sufficiently polished.

Further, in the silicon wafer according to the present invention, particle generation caused in wafer handling can be remarkably reduced without the flatness of the peripheral portion of the wafer lowered, so that it becomes possible that particles do not attach to the wafer surface. Moreover, in the silicon wafer according to the present invention, it becomes possible that decrease of resistivity due to autodoping during epitaxial growth is not brought about.

### Brief Explanation of the Drawings

Fig. 1 is a partial cross-sectional schematic view showing a peripheral portion of a silicon wafer according to the present invention.
Fig. 2 is a schematic view showing an apparatus for polishing a disk-shaped workpiece according to the present invention.
Fig. 3 is a schematic view showing a polishing apparatus according to conventional art 1.
Fig. 4 is a schematic view showing a polishing apparatus according to conventional art 2.
Fig. 5 is an explanatory view showing a conventional method for removing an oxide film on a chamfered portion of a wafer.
Fig. 6 is a partial cross-sectional schematic view showing a peripheral portion of a silicon wafer in which an oxide film is formed on a back surface.
Fig. 7 is a graph showing results of measuring a thickness of an oxide film on a peripheral portion of a back surface of each silicon wafer in Examples 1-3 and Comparative examples 1 - 3 after a silicon thin film is formed on each wafer.
Fig. 8 is a graph showing results of measuring the number of particles on a surface of each silicon wafer in Examples 1 - 3 and Comparative examples 1 - 3 after transfer.
Fig. 9 is a graph showing results of measuring resistivity of a peripheral portion of a front surface of each silicon wafer in Examples 1 - 3 and Comparative examples 1 - 3.
Fig. 10 is a cross-sectional schematic view showing a peripheral portion of a silicon wafer in which an epitaxial layer is formed on a front surface.

### Best Mode for Carrying out the Invention

Hereinafter, the present invention will be explained specifically.

As described above, there have been some cases where the problem that particles attach to a wafer surface occurs after a silicon wafer obtained after polishing of a chamfered portion or immersing in hydrofluoric acid to remove an oxide film according to conventional arts is subjected to handling. When the silicon wafer in which particles attach to the wafer surface as described above is used for manufacturing a semiconductor device, the wafer can become a cause for device failure.

It seems a cause for particle generation that a handling jig and the like are in contact with the oxide film on a peripheral portion of a back surface of the wafer to break the oxide film partially and bring about particle generation. In this case, the problem of particle generation will be solved when a diameter of a spacer is made smaller and the oxide film is removed over the region including a flat portion of a back surface in the above mentioned method in which the wafer is immersed in hydrofluoric acid. However, when this method is attempted, there occurs a new problem that resistivity of an epitaxial layer decreases due to autodoping in which impurities are introduced into the epitaxial layer from the back surface of the wafer exposed as a result of removal of the oxide film. Moreover, recently, in order to improve the device yield, a wafer peripheral region where the flatness has not been required so far (edge exclusion) is gradually becoming narrow, so that it is becoming unable to be ignored an influence on the wafer flatness by complete removal of the oxide film in the region of the peripheral portion. Moreover, there is an essential problem in the method in which a wafer is immersed in hydrofluoric acid that more steps are required for the method, so that the productivity decreases remarkably as compared with the removal of the oxide film by polishing.

The present inventors have realized that as a method for solving the above-mentioned problem, an oxide film on a peripheral portion of a back surface of a wafer is polished over a given distance from the outermost peripheral portion of the back surface so that a thickness of the polished oxide film decreases from inside to outside of the wafer. And they have found that when the wafer is polished over at least 2 mm inside from the outermost peripheral portion, breakage of the oxide film in handling and particle generation caused thereby can be prevented. Furthermore, they have found that, by this method, because the oxide film on the peripheral portion of the back surface is not completely removed, differently from the case where the wafer is immersed in hydrofluoric acid, it becomes possible that the back surface of the wafer is not exposed, and decrease of resistivity due to autodoping can be prevented. And the present inventors have investigated such a polishing method and a polishing apparatus suitable for performing such a polishing method, then they have completed the present invention.

Hereinafter, embodiments of the present invention will be explained with Figures. However, the present invention is not limited thereto.

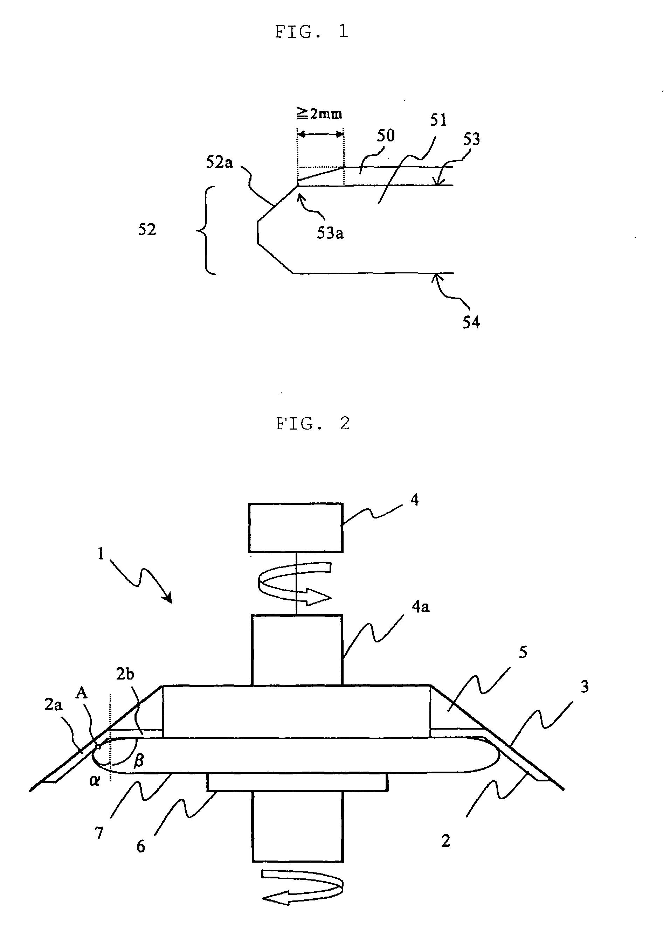

Fig. 1 is a partial cross-sectional schematic view showing a peripheral portion of a silicon wafer according to the present invention. In this silicon wafer 51, an oxide film 50 is formed on a back surface 53 of the wafer, and on a peripheral portion of the back surface over 2 mm or more inside from the outermost peripheral portion of the back surface 53a which is a boundary between a chamfered portion 52 and the back surface 53 of the wafer, a thickness of the oxide film 50 decreases from inside to outside of the wafer. By making the thickness of the oxide film on the peripheral portion of the back surface decrease as described above, it becomes possible to remarkably reduce particle generation caused in wafer handling and to obtain the wafer in which particles do not attach to the wafer surface. Moreover, as the oxide film is only made thin without being removed, flatness of the peripheral portion of the wafer is not lowered, and decrease of resistivity due to autodoping during epitaxial growth is not brought about. Here, when the part where the thickness of the oxide film decreases is narrower than 2 mm, measured from the outermost peripheral portion of the back surface, there cannot be obtained a sufficient effect that particles' attaching is prevented. Moreover, as for the upper limit, when the part where the thickness of the oxide film decreases measures up to approximately 6 mm, there can be obtained a sufficient effect that particles' attaching is prevented. The thickness of the oxide film 50 is not particularly limited, but it is preferable that the thickness is in the range of approximately 200 to 500 nm. A diameter of the wafer is also not particularly limited, for example, it may be set to be 300 mm, either of more and less than that will do. Furthermore, a polysilicon film called polysilicon back seal (PBS) to give the wafer 51 the gettering capability may be formed between the back surface 53 of the wafer and the oxide film 50.

In this case, it is preferable that the thickness of the oxide film 50 on the outermost peripheral portion 53a of the back surface is 50 nm or more thinner than the thickness of the oxide film on a central portion of the back surface of the wafer. For example, when the thickness of the oxide film on the central portion of the back surface is 350 nm, it is preferable that the thickness of the oxide film on the outermost peripheral portion of the back surface is 300 nm or less. When the oxide film has such a thickness, the effect that particles' attaching is prevented owing to the reduction of particle generation can be achieved with more certainty.

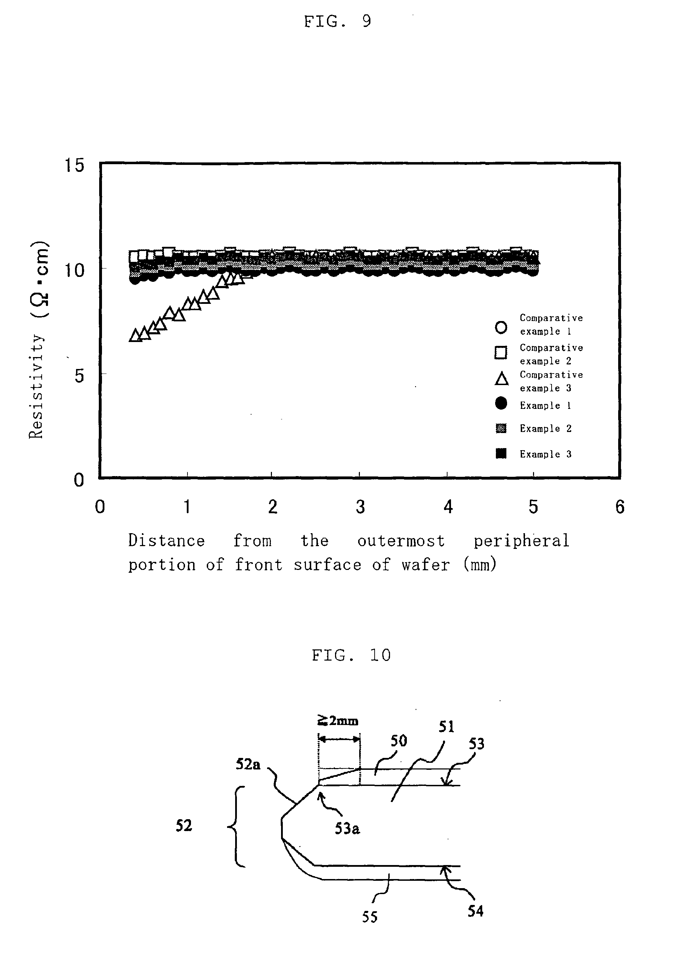

Moreover, as shown in Fig. 10, when an epitaxial layer 55 such as a silicon thin film is formed on a front surface 54 of the wafer, a silicon wafer in which particles do not attach to the surface of the epitaxial layer, and decrease of resistivity of the epitaxial layer due to autodoping is not brought about can be achieved.

The method for obtaining the silicon wafer in which the oxide film is made thin as described above is not particularly limited, and such a silicon wafer can be obtained by, for example, the polishing method according to the present invention explained below.

In a polishing method according to the present invention, an oxide film on a chamfered portion of a silicon wafer in which the oxide film is formed on a back surface side of the wafer is removed, and the oxide film on a peripheral portion of the back surface of the wafer is polished over at least 2 mm from the outermost peripheral portion of the back surface of the wafer so that a thickness of the polished oxide film decreases from inside to outside of the wafer. When the silicon wafer is polished so that the thickness of the oxide film gradually decreases as described above, it becomes possible to polish the oxide film so that particle generation due to breakage of the oxide film caused in wafer handling can be remarkably reduced, and particles due to particle generation can be prevented from attaching to the wafer surface. Moreover, as the oxide film is polished so that its thickness decreases, and not polished so that it is completely removed, it becomes possible to polish the oxide film so that the flatness of the peripheral portion of the wafer is not lowered, the back surface of the wafer is not exposed, and autodoping during epitaxial growth is not brought about. Here, when the part where the oxide film is polished so that its thickness decreases is narrower than 2 mm from the outermost peripheral portion of the back surface, there cannot be obtained a sufficient effect that particles' attaching is prevented. Moreover, as for the upper limit, when the part where the oxide film is polished so that its thickness decreases measures up to approximately 6 mm, there can be obtained a sufficient effect that particles' attaching is prevented.

Furthermore, it is preferable that the oxide film on the outermost peripheral portion of the back surface of the wafer is polished by 50 nm or more in polishing. When the oxide film is polished as described above, there can be obtained higher effect of reducing particle generation due to breakage of the oxide film, so that it becomes possible to surely prevent particles' attaching to the wafer surface.

Moreover, when the oxide film on the chamfered portion of the wafer is removed, and at the same time, the oxide film on the peripheral portion of the back surface is polished, it becomes possible that the wafer is polished with high productivity as compared with the case where the two steps are performed separately.

Moreover, when the polishing method comprises a step of removing the oxide film on a chamfered surface of a front surface side and a peripheral surface in the chamfered portion of the wafer, it becomes possible that the oxide film on the whole chamfered portion is surely removed and nodules are prevented from generating on the oxide film on the chamfered portion during epitaxial growth. A method for removing the oxide film as described above is not particularly limited, and, for example, it can be achieved by polishing. In this case, firstly the peripheral portion of the back surface and the chamfered surface of the back surface side of the wafer are polished with, for example, the polishing apparatus according to the present invention as described below, and subsequently, the wafer is held in the polishing apparatus with the front surface and the back surface of the wafer reversed, and the chamfered surface of the front surface side is polished, then, the peripheral surface in the chamfered portion can be polished with a roll buff as in the above-described conventional method 1. Moreover, the chamfered surface of the front surface side can be polished with the roll buff. Furthermore, the order in which removal steps are performed is not particularly limited, so that the peripheral surface or the chamfered surface of the front surface side can be first polished.

Moreover, when epitaxial growth of a silicon thin film or the like is performed on a front surface of the wafer after the oxide film on the chamfered portion is removed and the oxide film on the peripheral portion of the back surface is polished as described above, it becomes possible that a silicon wafer in which particles' attaching to a surface of the epitaxial layer due to a subsequent handling is prevented, and resistivity of the epitaxial layer does not decrease as autodoping is not brought about during epitaxial growth is produced.

A polishing apparatus to perform the above-described polishing method is not particularly limited, and, for example, the polishing method can be applicably performed with the polishing apparatus according to the present invention explained below.

Fig. 2 is a schematic view showing an apparatus for polishing a disk-shaped workpiece according to the present invention. This polishing apparatus 1 comprises a rotating body 3 having a surface inclined concentrically from outside to inside in a straight line in which a polishing pad 2 is attached to the surface. The surface is not restricted to a straight line. The surface may be inclined in a curved line such as a circular arc or a parabola. The rotating body 3 is rotated and driven by a motor 4 through a drive shaft 4a. Moreover, the polishing apparatus 1 comprises a workpiece holder 6 with which a disk-shaped workpiece 7 such as a silicon wafer is held, and a peripheral portion of the workpiece 7 is pressed against the polishing pad 2. This polishing pad 2 comprises a chamfered-portion polishing part 2a in which a chamfered portion of the workpiece is mainly polished and a back-surface polishing part 2b in which a back surface of the workpiece is mainly polished.

And, this polishing pad 2 is attached to the rotating body 3 so that an angle (α) which a tangent plane on a point A of contact between the chamfered-portion polishing part 2a and the chamfered portion of the workpiece 7 forms with a rotation axis is in the range of 40° to 70°, and an angle (β) which a contact surface between the back-surface polishing part 2b and the back surface of the workpiece forms with the rotation axis is in the range of 90° to 110°. The angles α and β are specifically the angles as shown in Fig. 2, and they are shown in Fig. 2 as the angles with respect to a dotted line drawn in parallel with the drive shaft 4a which is the rotation axis. When the angles α and β are in the above-described ranges, it becomes possible that the sufficient polishing is performed not only as to the whole region of the chamfered surface 52a of the back surface side of the workpiece 7 but also as to the whole of the region in the peripheral portion of the back surface over at least 2 mm from the outermost peripheral portion.

It becomes possible to attach the polishing pad 2 to the rotating body 3 as described above, by making the upper part of the polishing pad 2 which is usually not in contact with the chamfered portion inclined inside at a given angle with, for example, a bending jig 5, and this bended part can be made contacted with the peripheral portion of the back surface of the workpiece 7 as the back-surface polishing part 2b. The angle at which the polishing pad is bended is fixed so that the polishing parts form the angles as defined above in view of the shape of the chamfered portion of the workpiece. Moreover, when the polishing pad is bended, it can be bended in a straight line or in a gently curved line so that it forms such angles. The length of the chamfered-portion polishing part 2a can be appropriately fixed according to the size of the workpiece 7, the shape of the chamfered portion or the like. Moreover, the length of the back-surface polishing part 2b can be appropriately fixed according to the size of the workpiece 7, the width of the peripheral portion of the back surface to be polished (for example, 2 mm or more) or the like. Furthermore, hardness, thickness or the like of the polishing pad can be appropriately selected according to the property of the workpiece 7 or a use of polishing.

The workpiece holder 6 coupled to a vacuum pump not shown in Figures holds the workpiece 7 by vacuum suction. And the peripheral portion and the chamfered portion of the workpiece 7 are pressed against the polishing pad 2 for the entire perimeter under a proper pressure by an air cylinder and the like, with the main surface of the workpiece 7 held with the workpiece holder 6 kept perpendicular to the rotation axis of the rotating body 3. Then, by rotating the rotating body 3 and the disk-shaped workpiece 7 at a given rotating rate for a given period of time with pressing the workpiece, with providing a given polishing agent, the chamfered portion and the peripheral portion of the workpiece 7 can be polished.

So long as this polishing apparatus is used for polishing the back surface and the chamfered portion of the disk-shaped workpiece at the same time, the effect that polishing can be performed with high productivity can be obtained, so that the polishing apparatus can be used without particular limit. And particularly, when the disk-shaped workpiece is a silicon wafer, the polishing apparatus with high productivity in which an oxide film on a peripheral portion of a back surface of a silicon wafer is polished, and at the same time, an oxide film on a chamfered surface of a back surface side is polished to be removed can be achieved. Moreover, particularly, when the angles with regard to the polishing pad are set to be given values, it becomes possible that the oxide film on the peripheral portion of the back surface of the silicon wafer is polished over at least 2 mm from the outermost peripheral portion of the back surface so that a thickness of the polished oxide film decreases from inside to outside of the wafer, so that the polishing apparatus which can polish a silicon wafer in which particles do not attach to the wafer surface and autodoping during epitaxial growth is not brought about can be achieved.

Hereinafter, the present invention will be explained in further detail according to Examples. However, the present invention is not limited thereto.

### (Example 1)

A silicon wafer (P type 0.01Ω·cm : <100>) with a diameter of 300 mm produced by Czochralski method in which an oxide film was formed on a back surface and a chamfered portion was prepared, and the oxide film (thickness : 350 nm) on a peripheral portion of the back surface and the chamfered portion of the wafer was polished under the following conditions by using the polishing apparatus according to the present invention as shown in Fig. 2.
(Polishing conditions)
Polishing pad : Suba400 (manufactured by Rodel, Inc.), ASKER C 61, thickness 1.27 mm)
Angle with regard to polishing pad α:70°, β:90° Polishing pressure : 18 kgf
Polishing agent : EDGE MIRROR V (manufactured by Fujimi Incorporated)
Rotating rate of rotating body : 600 rpm
Polishing time : 45 sec

The peripheral portion of the back surface and the chamfered portion of the back surface side were polished under the above-described conditions, subsequently the wafer was sucked to a holder with the front surface and the back surface of the wafer reversed, then a chamfered surface of the front surface side was polished. A peripheral surface of the chamfered portion was polished with a roll buff.

### (Examples 2 and 3)

Polishing was performed under the same conditions as Example 1, except that each polishing pressure was set at 12 kgf (Example 2), 6 kgf (Example 3), and each polishing time was set at 30 sec (Example 2) and 20 sec (Example 3).

### (Comparative example 1)

Next, the same silicon wafer as Example 1 was polished with a conventional polishing apparatus as shown in Fig. 3 under the following conditions.
(Polishing conditions)
Polishing pad : Suba400 (manufactured by Rodel, Inc.), ASKER C 61, thickness 1.27 mm)
Polishing pressure: 2 kgf
Polishing agent: EDGE MIRROR V (manufactured by Fujimi Incorporated)
Rotating rate of rotating body : 800 rpm
Polishing time : 360 sec
Inclination angle of stage θ : 55°

The chamfered surface of the back surface side was polished under the above-described polishing conditions, subsequently the wafer was sucked to the holder with the front surface and the back surface of the wafer reversed, then the chamfered surface of the front surface side was polished.

### (Comparative example 2)

Next, the same silicon wafer as Example 1 was polished under the same conditions as Example 1 except that a conventional polishing apparatus as shown in Fig. 4 in which a polishing pad does not comprise a back-surface polishing part was used.

### (Comparative example 3)

By using the method shown in Fig. 5, the same silicon wafers as Example 1 were stacked with spacers made of vinyl chloride having a diameter of 297 mm and a thickness of 1 mm put between the wafers, then the wafers were immersed in a 5% hydrofluoric acid solution for three minutes to remove oxide films on chamfered portions.

Then, by epitaxial method, silicon thin films were made grown on the front surfaces of the silicon wafers treated according to the above-described Examples 1 - 3 and Comparative examples 1 - 3.

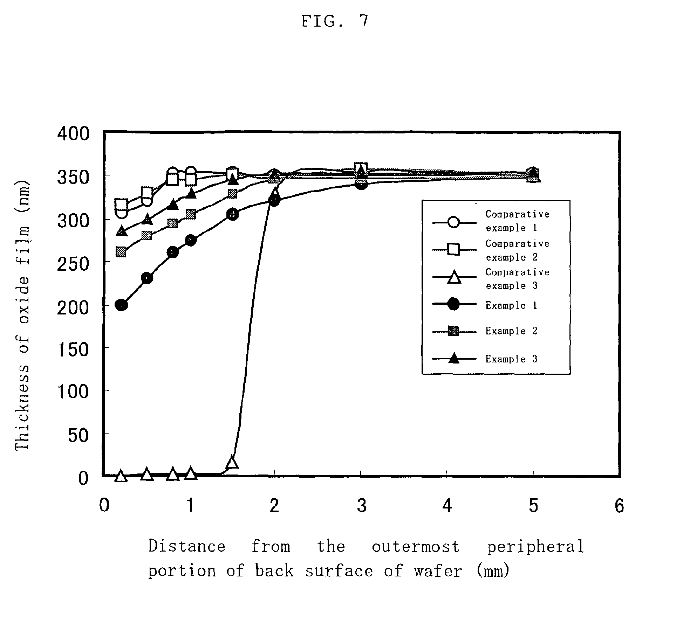

Next, the thickness of the oxide films on the peripheral portions of the back surfaces of these silicon wafers was measured with film thickness measuring device of interference fringe type (TFM120 : manufactured by Orc Manufacturing Co., Ltd.). The results are shown in Fig. 7.

As is obvious from Fig. 7, in each of Examples 1 - 3, by polishing, the thickness of the oxide film gently decreases toward outside from the position that is at least approximately 2 mm (approximately 3 mm in Example 1) distant from the outermost peripheral portion of back surface of the wafer, and on the outermost peripheral portion of the back surface, the thickness of the oxide film decreases by 50 nm or more as compared with the original thickness of the oxide film (350 nm).

Moreover, in each of Comparative examples 1 and 2, by polishing, the thickness of the oxide film just slightly decreases only over the region outside of the position that is at least approximately 1 mm distant from the outermost peripheral portion of the back surface, and also the decrease amount of the thickness of the oxide film on the outermost peripheral portion of the back surface is less than 50 nm. Moreover, in Comparative example 3, the oxide film is removed completely up to the position that is 1.5 mm distant from the outermost peripheral portion of the back surface.

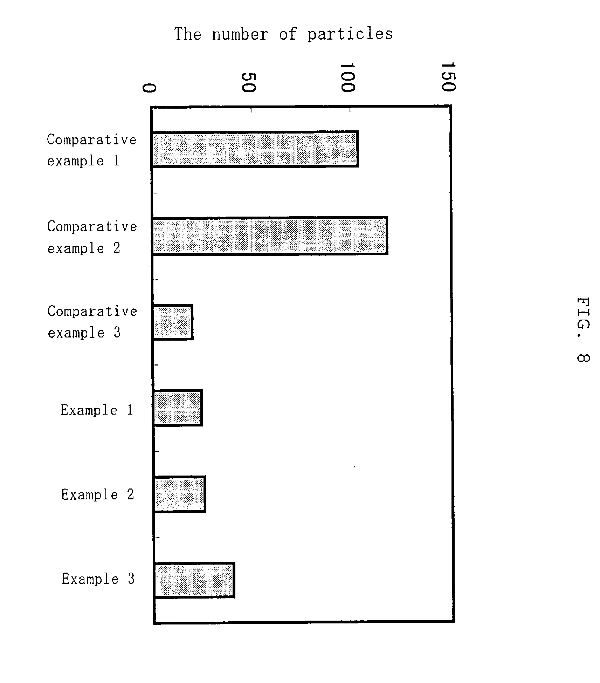

Next, each wafer was transferred with a robot transfer device for five times, then the number of particles on each wafer surface was measured with a particle counter (LS6500 : manufactured by Hitachi Electronics Engineering Co., Ltd.). The results are shown in Fig. 8. As is obvious from Fig. 8, it is found that, in Comparative examples 1 and 2, the numbers of particles on the wafers are remarkably larger than those on the wafers of Comparative example 3 and Examples 1 - 3.

Next, each resistivity of the peripheral portions of the front surfaces of the wafers on which silicon thin films were formed by epitaxial growth was measured with SR measuring device (manufactured by SSM Inc.). The results are shown in Fig. 9. As is obvious from Fig. 9, decrease of resistivity which was thought to be caused by autodoping was observed in Comparative example 3.

Namely, it was confirmed that as for silicon wafers of Examples 1 - 3 according to the present invention, the numbers of particles attaching to the wafer surfaces were remarkably small, and decrease of resistivity of epitaxial layers due to autodoping was not observed.

### (Examples 4 - 5, Comparative examples 4 - 6)

Next, in order to confirm the effects of the polishing apparatus according to the present invention, polishing was performed with the angles α and β with regard to the polishing pad changed as follows. The polishing conditions were the same as Example 1 except for the angles.

| | |
|---|---|
| Comparative example 4 | α:30°, β : 90° |
| Example 4 | α:40°, β : 90° |
| Comparative example 5 | α : 80°, β : 90° |
| Comparative example 6 | α:70°, β : 120° |
| Example 5 | α : 70°, β : 110° |

Each wafer polished under the above-described conditions was transferred with a robot transfer device for five times, then the thickness of the oxide films on the chamfered portions and the peripheral portions of the back surfaces was measured with film thickness measuring device of interference fringe type (TFM120). Further, the number of particles on each wafer surface was measured with a particle counter (LS6500). The results are shown in Table 1.

**(Table 1)**

| | Measurement results of oxide films | Measurement results of the numbers of particles |
|---|---|---|
| α : 30°, β : 90° | The oxide film was left on the inner side of the chamfered surface. | 152 |
| α : 40°, β : 90° | The oxide film on the chamfered portion was removed completely, and the peripheral portion of the back surface was also polished over 2 mm or more inside from the outermost peripheral portion. | 22 |
| α :80° , β : 90° | The oxide film was left on the peripheral side of the chamfered surface. | 136 |
| α: 70°, β: 120° | The peripheral portion of the back surface was polished over only approximately 1.5 mm inside from the outermost peripheral portion. | 108 |
| α: 70°, β: 110° | The oxide film on the chamfered portion was removed completely, and the peripheral portion of the back surface was also polished over 2 mm or more inside from the outermost peripheral portion. | 32 |

It is found from the results shown in Table 1 that when a wafer is polished with the polishing apparatus in which the angles α and β with regard to a polishing pad are determined according to the present invention, removal of an oxide film on a chamfered portion and polishing of a peripheral portion of a back surface are sufficiently achieved, and a wafer in which the number of particles that generate is remarkably small can be obtained.

Moreover, the present invention is not limited to the above-described embodiments. The above-described embodiments are mere examples, and those having the substantially same constitution as that described in the appended claims and providing the similar action and advantages are included in the scope of the present invention.

## Claims

1. A method for polishing a silicon wafer, in which an oxide film is formed on a back surface side of the wafer, wherein at least, the oxide film on a chamfered portion of the silicon wafer is removed, and the oxide film on a peripheral portion of the back surface of the wafer is polished over at least 2 mm from the outermost peripheral portion of the back surface of the wafer so that a thickness of the polished oxide film decreases from inside to outside of the wafer.

2. The method for polishing a silicon wafer according to claim 1, wherein the oxide film on the outermost peripheral portion of the back surface of the wafer is polished by 50 nm or more.

3. The method for polishing a silicon wafer according to claim 1 or 2, wherein the oxide film on the chamfered portion of the wafer is removed, and at the same time, the oxide film on the peripheral portion of the back surface of the wafer is polished.

4. The method for polishing a silicon wafer according to any one of claims 1 - 3, comprising further a step of removing the oxide film on a chamfered surface of a front surface side and a peripheral surface in the chamfered portion of the wafer.

5. The method for producing a silicon wafer, wherein after the oxide film on the chamfered portion is removed and the oxide film on the peripheral portion of the back surface of the wafer is polished by the polishing method according to any one of claims 1 - 4, epitaxial growth is performed on a front surface of the wafer.

6. An apparatus for polishing a disk-shaped workpiece, comprising, at least, a rotating body having a surface inclined concentrically from outside to inside in a curved line or a straight line in which a polishing pad is attached to the surface; a driving means rotating and driving the rotating body; a workpiece holder holding the disk-shaped workpiece and pressing a peripheral portion of the workpiece against the polishing pad, wherein the polishing pad comprises a chamfered-portion polishing part in which a chamfered portion of the workpiece is polished and a back-surface polishing part in which a back surface of the workpiece is polished, and the polishing pad is attached to the rotating body so that an angle (α) which a tangent plane on a point of contact between the chamfered-portion polishing part and the chamfered portion of the workpiece forms with a rotation axis is in the range of 40° to 70°, and an angle (β) which a contact surface between the back-surface polishing part and the back surface of the workpiece forms with the rotation axis is in the range of 90° to 110°.

7. The polishing apparatus according to claim 6, wherein the disk-shaped workpiece is a silicon wafer.

8. A silicon wafer in which an oxide film is formed on a back surface of the wafer, wherein, at least, on a peripheral portion of the back surface over at least 2 mm from the outermost peripheral portion of the back surface of the wafer, a thickness of the oxide film decreases from inside to outside of the wafer.

9. The silicon wafer according to claim 8, wherein the thickness of the oxide film on the outermost peripheral portion of the back surface of the wafer is 50 nm or more thinner than the thickness of the oxide film on a central portion of the back surface of the wafer.

10. The silicon wafer according to claim 8 or 9, wherein an epitaxial layer is formed on a front surface of the wafer.
